(19) Europäisches Patentamt
European Patent Office
Office européen des brevets

(11) EP 0 989 133 A2

(12) EUROPEAN PATENT APPLICATION

(43) Date of publication:
**29.03.2000 Bulletin 2000/13**

(51) Int. Cl.[7]: **C07F 1/00**, C23C 16/00

(21) Application number: **99307127.3**

(22) Date of filing: **08.09.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **21.09.1998 KR 9838968**

(71) Applicant: **ROHM AND HAAS COMPANY**
**Philadelphia, Pennsylvania 19106-2399 (US)**

(72) Inventor: **Shin, Hyun-Koock**
**Suwon, Kyungki-Do 442-470 (KR)**

(74) Representative:
**Buckley, Guy Julian et al**
**ROHM AND HAAS (UK) LTD.**
**European Operations Patent Department**
**Lennig House**
**2 Mason's Avenue**
**Croydon CR9 3NB (GB)**

# (54) Solution of copper compound for the copper film deposition from chemical vapor deposition and the method of synthesis

(57) Vapor deposition precursor compositions comprising an organometallic compound and a solvent are disclosed. Also disclosed are methods of preparing the compositions as well as methods of vapor depositing a metal film.

EP 0 989 133 A2

## Description

Background of the Invention

This invention generally relates to compounds used for the chemical vapor deposition of metal films. In particular, this invention relates to precursor compounds for use in the chemical vapor deposition of copper films.

In the semiconductor industry, technological and material development have resulted in the miniaturization, high reliability, high speed, high functionality, and high degree of integration of devices, such as semiconductor integrated circuits. This miniaturization of semiconductor devices requires a narrower wiring width.

Currently, 64 mega DRAM (dynamic random access memory), devices use aluminum metal wire circuits and the width of these circuits is becoming narrower, to 0.25, 0.18, and 0.15 microns ("μm"). In the next generation memory devices, such as the larger 256 mega class memory devices, as well as 1 giga ("G") and 4 G class high memory devices, it is expected that the aluminum wiring will be replaced with copper wiring.

Aluminum is low in durability toward electromigration ("EM") phenomena. Thus, when a high density current flows through a narrow aluminum conductor, the wiring is easily severed resulting in low reliability of semiconductor devices. This problem occurs frequently. For copper wiring, the durability toward electromigration is higher than that of aluminum wiring and, thus, the severing of a circuit is prevented and a high reliability is achieved. Also, compared to the electric resistance of aluminum (Rs = 2.56 microOhms-cm), the electric resistance of copper (Rs = 1.67 microOhms-cm) is low which results in high signal transmission which ultimately speeds up the transmission of semiconductor devices.

Currently, the metal wiring in 64 mega DRAM device manufacture is formed solely by a sputtering method using a metal target in the metal wire vapor deposition process. In the next generation memory devices described above, the circuit line width would be less than 0.25 microns (μm) and the sputtering process in the vapor deposition process would be unsuitable due to a high aspect ratio (depth/diameter) of a contact and via hole formed during the metal vapor deposition.

To overcome this problem, the chemical vapor deposition process ("CVD") has been studied for a long time. A highly beneficial effect of the CVD process is that it has a high step coverage and an improved burying process of the contact/via hole. As a result of the study, copper (Cu) wiring by vapor deposition in the manufacture of the next generation class of memory devices will be the foundation of the necessary technology. This copper (Cu)-CVD method is considered to be the imperative method.

In the thin metal film vapor deposition process, primarily a metal compound is used as the source, i.e. the precursor. The chemical properties and the selection of the compound greatly affect the CVD process. Therefore, prior to the selection of the deposition method, the selection and development of the precursor are the first factors to be considered.

Despite the importance of the role of the precursor, the development of the absolute precursors for Cu-CVD started rather late. The reason for this is that the demand for the thin metal film vapor deposition using the CVD method has been rising with the demand for the development of the next generation memory devices and the demand from the semiconductor industry.

Divalent copper ($Cu^{+2}$) compounds were used as precursors in the early stages of copper thin film deposition by the chemical vapor deposition process. The divalent copper compound precursors are stable in atmosphere and easy to handle, and they have been widely commercialized which made them easily available. However, those compounds have some disadvantages for copper (Cu)-CVD, such as low vapor pressure, low deposition rate, high vapor deposition temperature, and the presence of impurities in the vapor deposited film layer.

To overcome such problems in the divalent copper compounds, in the nineteen-nineties, many monovalent copper compounds ($Cu^+$) have been used as precursors in Cu-CVD. Examples of monovalent copper compounds are those having a chemical formula of $(C_5HO_2F_6)Cu(PC_3H_9)$ [or 1,1,1,5,5,5-hexafluoro-2,4-pentanedionate(trimethylphosphine) copper (I) or $C_8H_{10}O_2CuF_6P$ or (hfac)Cu($PMe_3$)], a compound having a chemical formula of $(C_5HO_2F_6)Cu(C_8H_{12})$ [or 1,1,1,5,5,5-hexafluoro-2,4-pentanedionate(1,5-cyclooctadiene)copper (I) or $(C_{13}H_{13}O_2CuF_6)$ or (hfac)Cu(1,5-COD), herein after], a compound having a chemical formula of $(C_5HO_2F_6)Cu(C_5H_{12}Si)$ [or 1,1,1,5,5,5-hexafluoro-2,4-pentanedionate(vinyltrimethylsilane) copper (I) or $C_{10}H_{13}O_2CuF_6Si$ or (hfac)Cu(VTMS), hereinafter), a compound having a chemical formula of $(C_5HO_2F_6)Cu(C_5H_{12}O_3Si)$ [or 1,1,1,5,5,5-hexafluoro-2,4-pentanedionate(vinyltrimethoxysilane) copper (I) or $C_{10}H_{13}O_5CuF_6Si$ or (hfac)Cu(VTMOS), hereinafter), and a compound having a chemical formula of $(C_5HO_2F_6)Cu(C_5H_{10})$ [or 1,1,1,5,5,5-hexafluoro-2,4-pentanedionate(1-pentene) copper (I) or $C_{10}H_{11}O_2CuF_6$ or (hfac)Cu(1-pentene), hereinafter.] These monovalent copper compounds, which were improvements over the divalent copper compounds, also had problems when used as absolute Cu-CVD precursors.

(Hfac)Cu(1,5-COD) was used for a long time as the precursor in copper thin film chemical vapor deposition processes, as well as (hfac)Cu($PMe_3$), as reported by H.-K. Shin et al in Chemistry of Materials, 1990, 2, 636 and 1992, 4, 788 which enabled the formation of high purity copper thin films at low temperatures. These compounds have suitable properties as precursors but they are solid compounds and control of the transport rate of the precursors is difficult, which is a disadvantage.

U.S. Patent No. 5,085,731 (Norman) discloses an improved liquid phase precursor compound, (hfac)Cu(VTMS). Korean Patent Application 95-17120 (Shin) discloses (hfac)Cu(VTMOS). Additionally, (hfac)Cu(1-pentene) was reported by Hyun-Kook Shin et al. on page 219 of Material Research Society Symposium Proceeding, Volume 427, together with other liquid compounds used for Cu-CVD precursors.

The liquid compounds, (hfac)Cu(VTMS), (hfac)Cu(VTMOS) and (hfac)Cu(1-pentene) are copper thin film chemical vapor deposition precursors that deposit high purity copper films at low temperature. The precursor properties are similar to those of the solid precursors mentioned above. However, the compounds, (hfac)Cu(VTMS) and (hfac)Cu(1-pentene) gradually decompose at room temperature and have serious problems as precursors in the manufacture of semiconductor devices in relation to the reproducibility of the manufacture. Compared to these, the precursor compound (hfac)Cu(VTMOS), which has been applied for patent by the present inventors, exhibited superior properties as a precursor compound but its relative vapor pressure is low, hence, its vapor deposition rate is low. In order to increase the vapor deposition rate, the precursor temperature was raised to 70° C and the heating process caused a gradual decomposition, which is a problem.

In order to prepare the optimum precursors for Cu-CVD process, the shortcomings of thermal instability and the low vapor deposition rate, etc. need to be improved and the surface of the high purity copper thin film should be smooth. To attain such goals, the Le Chatelier principle was applied, which states that when an equilibrium state is disturbed, the equilibrium shifts toward the direction where the disturbance lessens; i.e., in this case the ligands, Lewis acid or base, used in the manufacturing process of the chemical compounds were used to dissolve the precursor compound to prepare a precursor solution. The resulting copper compound solution was fed to a vaporizer from a storage tank at a given feed rate from a liquid precursor vaporizer (hereinafter "LPV"), and then a flash vaporization can be achieved. In such a way, the problems of the prior precursors, such as thermal stability, vapor deposition and quantitative precursor feed rate, were resolved through study using (hfac)Cu(VTMS). The study was positive, but the thermal stability problem has not yet been solved. For this reason, the clogging of the vaporizer and the rough surface of the film have not been improved.

Summary of the Invention

It has now been found that certain copper compounds solve the problems of known precursors for Cu-CVD applications and provide a wide selection of precursors through the use of Lewis acid or base solvents to prevent the clogging of the vaporizer.

The present invention provides a vapor deposition precursor composition, comprising an organometallic compound of the Formula

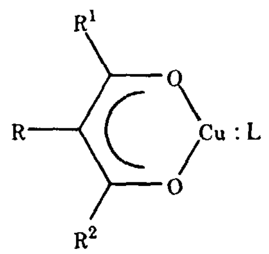

(I)

wherein R is selected from hydrogen, fluorine, perfluoroaryl or alkyl or perfluoroalkyl group of 1 to 4 carbons; $R^1$ and $R^2$ are each independently selected form alkyl or perfluoroalkyl group of 1 to 7 carbons; and L is a Lewis base selected from an organic compound or an organic metal compound capable of providing an unshared pair of electrons to the copper metal center; and a solvent selected from one or more Lewis bases, one or more Lewis acids, or mixtures thereof.

The present invention also provides a process for copper film formation comprising the step of vapor depositing a copper film on a substrate, wherein the source of the copper film is a vapor deposition precursor composition comprising an organometallic compound of the Formula

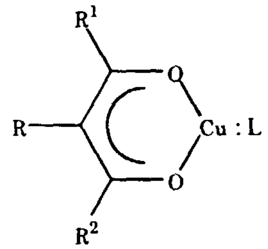

(I)

wherein R is selected from hydrogen, fluorine, perfluoroaryl or alkyl or perfluoroalkyl group of 1 to 4 carbons; $R^1$ and $R^2$ are each independently selected form alkyl or perfluoroalkyl group of 1 to 7 carbons; and L is a Lewis base selected from an organic compound or an organic metal compound capable of providing an unshared pair of electrons to the copper metal center; and a solvent selected from one or more Lewis bases, one or more Lewis acids, or mixtures thereof.

Detailed Description of the Invention

This invention pertains to precursor compositions useful in the vapor deposition of copper film as wiring on semiconductor devices and methods of vapor depositing copper films. Specifically, the precursors are useful in the formation of a copper metal film layer on a diffusion barrier layer or adhesion layer on a silicon substrate.

This invention solves the problems of the known precursor compounds and precursor solutions used for copper film vapor deposition and provides a wide selection of precursors through the use of Lewis acid or base solvents to prevent the clogging of the vaporizer. The invention further provides precursor compositions with effective molar concentrations to be reproducible in copper film vapor deposition processes and a copper thin film vapor deposition process using the compositions.

This invention pertains to new copper compound compositions for copper metal thin film vapor deposition and retains the advantages of the prior precursor compounds while improving their shortcomings. Such compounds are represented by Formula I and the compound is dissolved in one or more Lewis bases selected from the compounds defined by Formulae II to V, one or more Lewis acids defined by Formula VI, or a mixtures thereof.

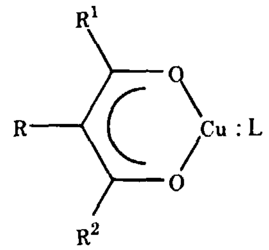

(I)

In Formula I, R is selected from hydrogen, fluorine, perfluoroaryl, or an alkyl or perfluoroalkyl group of 1 to 4 carbons; $R^1$ and $R^2$ are independently an alkyl or perfluoroalkyl group of 1 to 7 carbons; and L is a Lewis base selected from an organic compound or an organic metal compound capable of providing an unshared pair of electrons to the copper metal center. Examples of Lewis bases are alkenes represented by Formula II, alkynes represented by Formula III and silanes represented by Formulae IV or V.

$$(R^3)(R^4)C{=}C(R^5)(R^6) \qquad \text{(II)}$$

$$R^7C{\equiv}CR^8 \qquad \text{(III)}$$

In the above Formula II, $R^3$, $R^4$, $R^5$ and $R^6$ are each independently hydrogen, fluorine or an alkyl, perfluoroalkyl or alkoxy group of 1 to 6 carbons. In Formula III, $R^7$ and $R^8$ are each independently hydrogen, or an alkyl perfluoroalkyl or alkoxy group of 1 to 6 carbons.

$$(R^9)(R^{10})C{=}CH{-}(CHR^{11})_n{-}Si(OR^{12})_3 \qquad \text{(IV)}$$

$$(R^{10})C{\equiv}C{-}(CHR^{11})_n{-}Si(OR^{12})_3 \qquad \text{(V)}$$

In the above Formula IV, $R^9$, $R^{10}$, $R^{11}$ and $R^{12}$ are each independently hydrogen, fluorine or an alkyl or perfluoroalkyl group of 1 to 4 carbons, and n is an integer of 0 to 3. In Formula V, $R^{10}$, $R^{11}$ and $R^{12}$ are each independently hydrogen, fluorine or an alkyl or perfluoroalkyl group of 1 to 4 carbons, and n is an integer of 0 to 3.

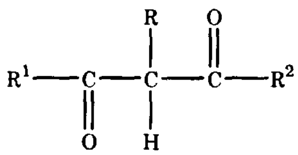

(VI)

In the above Formula VI, R, $R^1$ and $R^2$ are as defined in Formula I.

Among the compounds represented by Formula II, the preferred compounds are 1-alkenes, represented by Formula VII. Among the compounds represented by Formula III, the preferred ones are 1-alkynes, represented by Formula VIII. Among the compounds represented by Formula IV, the preferred one is trialkoxyvinylsilane, represented by Formula IX.

$$H_2C{=}CHR^{13} \qquad \text{(VII)}$$

$$HC{\equiv}CR^{14} \qquad \text{(VIII)}$$

$$H_2C{=}CH{-}Si(OR^{15})_3 \qquad \text{(IX)}$$

In the above Formula VII, $R^{13}$ is an alkyl, perfluoroalkyl or alkoxy group of 1 to 6 carbons. In the above Formula

VIII, $R^{14}$ is an alkyl, perfluoroalkyl or alkoxy group of 1 to 6 carbons. In Formula IX, $R^{15}$ is an alkyl or perfluoroalkyl group of 1 to 4 carbons.

As described above, the compounds of Formula I are dissolved in one or more Lewis bases, L, represented by Formulae II to V and Formulae VII to IX or one or more Lewis acids represented by Formula VI. Also, the compounds can be dissolved in a mixture of one or more Lewis bases and one or more Lewis acids. The resulting copper compound compositions are useful in copper thin film vapor deposition processes. The preparation of these compositions is described below. During the course of the reaction, exposure to air was prevented by using Schlenk line technology while carrying out the reaction under an inert gas stream, such as nitrogen or argon.

A sodium hydride suspension in diethyl ether was chilled with dry ice and a Lewis acid of Formula VI was added dropwise to obtain a diketone sodium salt (Formula X) which was then stored.

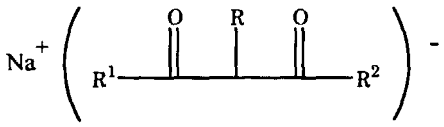

(X)

Independently, white powder of cuprous chloride (CuCl) was dissolved in, and reacted with, a Lewis base of Formula II to Formula V to prepare a complex salt which was then reacted with the compound of Formula X in a solvent such as hexane, pentane or diethyl ether to obtain the compound of Formula I.

The compounds of Formula I prepared according to the above procedure were dissolved in one or more Lewis bases of Formula II to Formula V, or one or more Lewis acids of Formula VI. Alternatively, the compounds of Formula I can be dissolved in a mixed solvent of one or more Lewis bases and one or more Lewis acids. In this way, the copper compounds, copper vapor deposition precursors, and compositions of the invention are prepared.

It is preferred that the solvent in the compositions of the invention is a mixture of one or more Lewis bases and one or more Lewis acids. It is more preferred that the solvent is a mixture of 1-pentene and 1,1,1,5,5,5-hexafluoro-2,4-pentanedione or a mixture of vinyltrimethoxysilane and 1,1,1,5,5,5-hexafluoro-2,4-pentanedione. When the compositions of the invention comprise a mixture of 1-pentene and 1,1,1,5,5,5-hexafluoro-2,4-pentanedione, it is preferred that the 1-pentene is present in an amount of 20 to 50% by weight of the composition and the 1,1,1,5,5,5-hexafluoro-2,4-pentanedione is present in an amount of less than 10% by weight of the composition. When the compositions of the present invention comprise a mixture of vinyltrimethoxysilane and 1,1,1,5,5,5-hexafluoro-2,4-pentanedione, it is preferred that the vinyltrimethoxysilane is present in an amount less than 50% by weight of the compositin and the 1,1,1,5,5,5-hexafluoro-2,4-pentanedione is present in an amount of less than 10% by weight of the composition.

In the above reaction, a nonpolar solvent such as hexane or pentane was used to improve the yield of the product and the sodium (Na) content in the product can be reduced by the use of solvents.

The above-mentioned manufacturing process is shown in Equations 1 to 4.

Equation 1

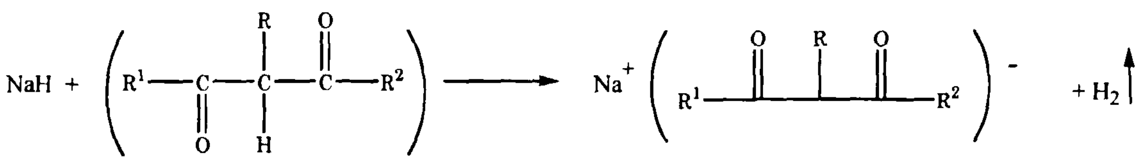

Equation 2

$$CuCl + L \longrightarrow ClCuL$$

Equation 3

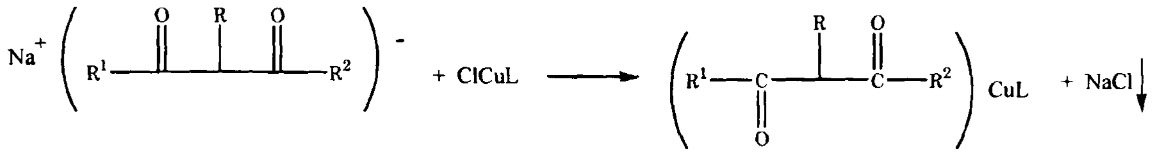

Equation 4

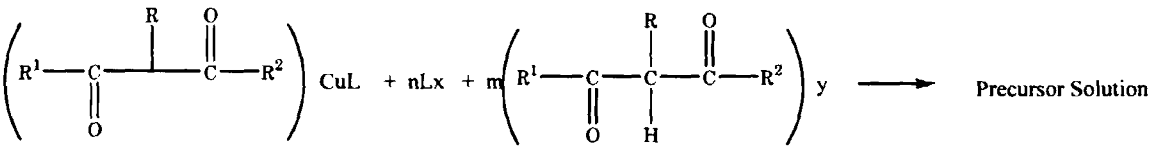


In the above Equations, R, $R^1$ and $R^2$ are as defined in Formula I, where x and y are integers between 0 and 100. Thus, when x or y is zero, the other cannot be zero. This is calculated by the mathematical formula $[B/(A + B)] \times 100 = x(y)$ . In this formula, A is the weight of the designated compound, and B is the weight of the Lewis base, Lewis acid, or mixture thereof.

The Lewis bases used in Equations 1 to 4 are represented by Formulae VII and IX. Examples of such Lewis bases include 1-pentene ($CH_2=CHCH_2CH_2CH_3$), which is a 1-alkene, and trimethoxyvinylsilane (VTMOS; $H_2C=CHSi(OCH_3)_3$), which is a trialkoxyvinylsilane. Examples of Lewis acids represented by Formula VI include 1,1,1,5,5,5-hexafluoro-2,4-pentane (hereinafter "hfacH"). These acids and bases are especially suitable for precursor solution preparation for copper film vapor deposition.

This invention will be discussed in detail with an emphasis on the use of the solution prepared from (hfac)Cu(VTMOS), which is a compound of Formula I and prepared using a trimethoxyvinylsilane, as the circuit wiring material in semiconductor devices.

The reactions of the compound (hfac)Cu(VTMOS) in the copper vapor deposition process are described by stages in Equations 5 and 6 in the vapor deposition of a copper film.

Equation 5

$$2(hfac)Cu^{+}(VTMOS) \rightarrow 2(hfac)Cu^{+} + 2VTMOS$$

Equation 6

$$2(hfac)Cu^{+} \rightarrow Cu^{0} + Cu^{+2}(hfac)_2$$

Reviewing the above reaction mechanism, (hfac)Cu(VTMOS) compound was adsorbed on the substrate to be vapor deposited with a copper film after entering a reactor, and a Lewis base, VTMOS, is dissociated and provides a pair of unshared electrons to the center of the core at the stage of Equation 5, which is a rate determining step. The dissociation yields two moles of unstable copper intermediate, 2(hfac)$Cu^+$ and, in the second stage, 2(hfac)$Cu^+$ undergoes disproportionation to yield $Cu^{+2}(hfac)_2$ which is then removed by evaporation and the resulting $Cu^0$ is vapor deposited on the substrate as a copper film.

The compound of Formula I is formed favorably as shown in Equation 5. However, in the case of the compositions of the invention, in the first stage reaction defined Equation 5, the reaction takes place favorably in a reverse direction according to Le Chatelier's Principle when a Lewis base, which is a free ligand, a Lewis acid, or a mixture of a Lewis base and a Lewis acid were added to the compound of Formula I.

Therefore, the invention compositions containing a ligand suppresses the reaction described by Equation 5 when a precursor solution is heated in a vaporizer of a solution transport apparatus. Even if the compound is somewhat thermally unstable, the suppressing action inhibits the reaction in Equation 5 in a vaporizer. This ultimately inhibits the dissociation in the vaporizer and, thus, the clogging in the vaporizer is also inhibited.

The use of a solution containing a more thermally stable compound or a proper solution weight ratio (%) will result in the maximum inhibition of dissociation in a vaporizer and better vapor deposition of the film.

In the above-mentioned example, the copper film vapor deposition precursor composition, (hfac)Cu(VTMOS) solution in VTMOS, is more stable than the (hfac)Cu(VTMS) in VTMS solution which was developed by Schumacher Co. The reason for this is that (hfac)Cu(VTMOS) is thermally more stable. This alleviates the clogging in the vaporizer that occurs when the Schumacher solution is used.

Other advantages of the precursor compositions of the invention are that the dissociation of the compound in the vaporizer is inhibited and this minimizes the formation of byproducts which have a negative effect on the vapor deposition of the thin film. Ultimately, this results in a superior quality copper thin film by vapor deposition.

In the case of the compound (hfac)Cu(1-pentene) in 1-pentene solution, the compound itself is thermally unstable, but with the addition of 1-pentene to 20-50% weight ratio to the compound, the dissociation of the compound in a vaporizer can be prevented to the maximum degree. Thus, the solution formulation ratio in the study has an important role in the copper thin film vapor deposition process.

The use of the precursor compositions of the invention in the formation of thin films in semiconductor device manufacture allows for the development of a reproducible copper film vapor deposition process, which is the most important factor. The compositions of the invention also have a long shelf life at room temperature and the costs of VTMOS and 1-pentene, which are the additives used as the ligand and solvent, as well as the Lewis base, are lower than that of VTMS which is used in (hfac)Cu(VTMS) formulations. As far as the production cost is concerned, the cost is far less than the production cost of the (hfac)Cu(VTMS) solutions. The solutions of the invention not only are economical, but also provide superior quality vapor deposition precursor solutions.

As described above, the copper film vapor deposition precursor solutions of the invention consist of a compound represented by Formula I and one or more Lewis bases, one or more Lewis acids, or mixtures thereof. In the precursor compositions, the preferred Lewis bases designated by L include, a 1-alkene represented by Formula XI, a 1-alkyne represented by Formula XIII, a silane represented by Formulae XIV and Formula XV, and a silane represented by Formulae XVI and XVII. An especially preferred 1-alkene is that represented by Formula XII. A more preferred silane is represented by Formula XVIII, and an especially preferred silane is represented by Formula XIX.

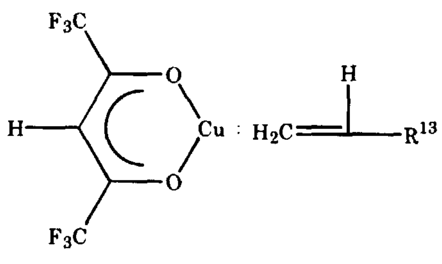

(XI)

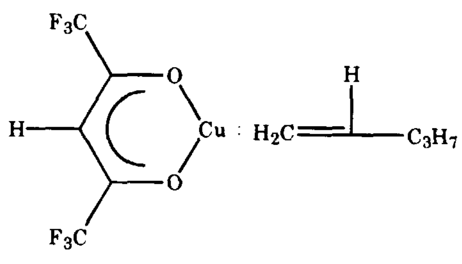

(XII)

In the above Formula XI, $R^{13}$ is an alkyl, perfluoroalkyl or alkoxy group of 1 to 6 carbons. When the compositions of the present invention comprise a copper compound of Formula XI, it is preferred that the solvent is a mixture of 1-pentene and 1,1,1,5,5,5-hexafluoro-2,4-pentanedione. It is more preferred that the 1-pentene is present in an amount

of 20% to 50% by weight of the composition and the 1,1,1,5,5,5-hexafluoro-2,4-pentanedione is present in an amount of less than 10% by weight of the composition.

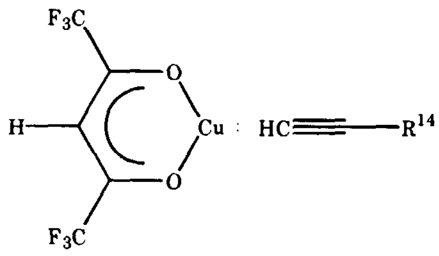

(XIII)

$$H_2C{=}CH{-}(CHR^{11})_n{-}Si(OR^{12})_3$$

(XIV)

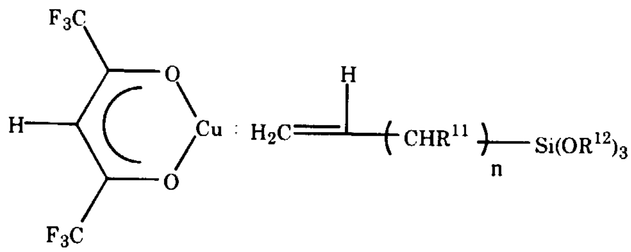

(XV)

$$HC{\equiv}C-(CHR^{11})_n-Si(OR^{12})_3$$

(XVI)

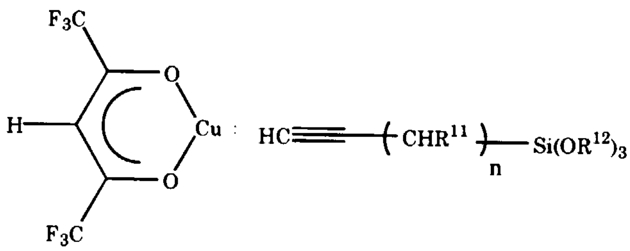

(XVII)

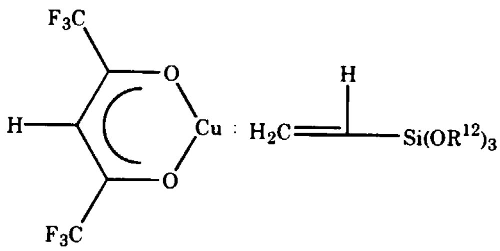

(XVIII)

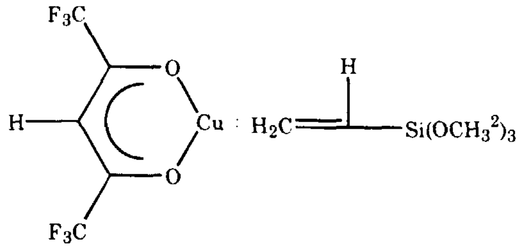

(XIX)

In the above Formula XIII, $R^{14}$ is an alkyl, perfluoroalkyl or alkoxy group of 1 to 6 carbons. In Formulae XIV and XVIII, $R^{11}$ and $R^{12}$ are each independently hydrogen, fluorine an alkyl or perfluoroalkyl group of 1 to 4 carbons, and n is an integer from 0 to 3. When the compositions of the present invention comprise a copper compound of Formula XV, it is preferred that the solvent is a mixture of vinyltrimethoxysilane and 1,1,1,5,5,5-hexafluoro-2,4-pentanedione. It is more preferred that the vinyltrimethoxysilane is present in an amount of less than 50% by weight of the composition and the 1,1,1,5,5,5-hexafluoro-2,4-pentanedione is present in an amount of less than 10% by weight of the composition.

The compositions of the present invention may be used as precursors for copper film formation in any chemical vapor deposition process. Examples of such vapor deposition processes include those where the energy for the excitation of the process gas is accomplished by thermal energy, plasma, or by the application of a bias potential to the substrate. Typically, argon, helium, nitrogen and hydrogen may be used as the carrier gas and the process gas with the compositions of the present invention. It is preferred that the substrate in the vapor deposition proces be heated to 100° to 250° C.

The preparation of the precursor compositions of the invention is discussed below with examples.

Example 1: Preparation of (hfac)Cu(VTMOS) Solution in VTMOS

A diethyl ether suspension containing 24 g (1 mole) of sodium hydride (NaH) was placed in a reactor chilled with an acetone-dry ice mixture (-78° C), and 208 g (1 mole) of 1,1,1,5,5,5-hexafluoro-2,4-pentanedione (hfacH) was added dropwise with stirring. White-gray Na-hfac precipitated and the hydrogen generated from the reaction was expelled from the reaction system.

After the completion of the addition of the 1,1,1,5,5,5-hexafluoro-2,4-pentanedione, the mixture in the reactor was gradually heated to room temperature in order to complete the reaction. The mixture was stirred further until no hydrogen evolved, about 3 hours. The volatile components in the mixture were then removed under vacuum and the white-gray color solid residue, which was $Na^+hfac^-$ was stored for subsequent processes.

Separately, 99 g (1 mole),of cuprous chloride (CuCl), a white-gray powder, were added to a reactor, chilled at 0° C, containing 148 g (1 mole) of vinyltrimethoxysilane (VTMOS) with stirring, and the mixture turned a dark brown color. Following the addition, the temperature of the mixture was raised to room temperature and then stirred for 3 hours to complete the formation of (VTMOS)CuCl which was subsequently reacted with the above $Na^+hfac^-$ in hexane. The mixture then changed to a yellowish-green color. In order to complete the mixing and the reaction, the mixture was stirred for about 6 hours at room temperature and the resulting mixture was filtered under a nitrogen stream to obtain the first yellowish-green filtrate. The residue on the filter was rinsed twice with 50 milliliters ("mL") each of hexane to obtain a secondary filtrate which was then mixed with the first filtrate. The volatile components in the mixed filtrate were removed under vacuum at room temperature and 320 g of a light green color, liquid compound, (hfac)Cu(VTMOS), were obtained.

The (hfac)Cu(VTMOS) was vacuum distilled at 50° C at $10^{-4}$ torr and the distillate collected in a receiver chilled with liquid nitrogen (-196° C) which yielded a high purity condensate. To the purified compound, a given amount of vinyltrimethoxysilane was added to obtain the invention light greenish precursor composition.

In order to study the thermal stability and the characteristics of the resulting solutions at various mixing ratios, the amount of vinyltrimethoxysilane was added within 100% range to prepare the solutions. The various solutions were subjected to proton nuclear magnetic resonance (NMR) to confirm the products. The results are listed in Table 1.

The location of the chemical shift of the proton spectrum of vinyltrimethoxysilane solution, while increasing the content of the added vinyltrimethoxysilane from 0% to 90%, moved from the down field side to the up field side. This

shift is similar to that of vinyltrimethoxysilane. Especially, the proton spectrum in the methoxy group showed almost no shift, but the proton spectrum of the vinyl group showed a large shift, which implies that the electron pair in the vinyltrimethoxysilane is utilized to form a bond to the copper metal center.

The shift location of the proton spectrum of vinyltrimethomysilane becomes one; this implies that a fast exchange reaction takes place between the vinyltrimethoxysilane solvent and (hfac)Cu(VTMOS) at room temperature. This further implies that vinyltrimethoxysilane solvent is an aid for improving of the stability of the compound, (hfac)Cu(VTMOS).

Table 1

| Compound Solution (%) [VTMOS / (hfac)Cu(VTMOS) + VTMOS] x 100 | NMR Analysis ($C_6D_6$, ppm) |
|---|---|
| 0 | δ 3.34 (s, 9H)<br>δ 4.38 (m, 3H)<br>δ 6.13 (s, 1H) |
| 10 | δ 3.37 (s, 12H)<br>δ 4.64 (m, 4H)<br>δ 6.12 (s, 1H) |
| 20 | δ 3.37 (s, 1H)<br>δ 4.92 (m, 5H)<br>δ 6.12 (s, 1H) |
| 50 | δ 3.37 (s, 35H)<br>δ 5.48 (m, 11H)<br>δ 6.12 (s, 1H) |
| 100 | δ 3.58 (s, 9H)<br>δ 6.01 (m, 3H) |

Example 2: Preparation of (hfac)Cu(1-pentene) Solution in 1-Pentene

$Na^+hfac^-$ was prepared according to the procedure of Example 1. 1-Pentene, 105 g (1.5 moles), was added to 99 g (1 mole) of a white powder of CuCl, and the mixture was stirred for about 3 hours at 0° C to obtain ClCu(1-pentene).

The previously prepared $Na^+hfac^-$ and ClCu(1-pentene) were mixed in pentane as the solvent at 0° C, and then proceeded according to Example 1 to prepare light green (hfac)Cu(1-pentene) which was then purified under vacuum at 0° C and $10^{-4}$ torr.

To the purified compound, (hfac)Cu(1-pentene), purified colorless 1-pentene was added at a given ratio to prepare precursor compositions of the invention. The precursor compositions at the various ratios were confirmed by proton nuclear magnetic resonance analysis, and the results are reported in Table 2.

Table 2

| Compound Solution (%) [1-pentene / (hfac)Cu(1-pentene) + 1-pentene] x 100 | NMR Analysis ($C_6D_6$, ppm) |
|---|---|
| 0 | δ 0.65 (t, 3H)<br>δ 1.08 (h, 2H)<br>δ 1.46 (q, 2H)<br>δ 3.62 (m, 2H)<br>δ 4.48 (m, 1H)<br>δ 6.19 (s, 1H) |
| 10 | δ 0.67 (t, 4.2H)<br>δ 1.10 (h, 2.8H)<br>δ 1.53 (q, 2.8H)<br>δ 3.83 (m, 2.8H)<br>δ 4.65 (m, 1.4H)<br>δ 6.19 (s, 1H) |
| 20 | δ 0.72 (t, 5.4H)<br>δ 1.13 (h, 3.6H)<br>δ 1.60 (q, 3.6H)<br>δ 4.08 (m, 3.6H)<br>δ 4.82 (m, 1.8H)<br>δ 6.18 (s, 1H) |
| 50 | δ 0.78 (t, 12H)<br>δ 1.24 (h, 8H)<br>δ 1.80 (q, 8H)<br>δ 4.60 (m, 8H)<br>δ 5.48 (m, 4H)<br>δ 6.18 (s, 1H) |
| 100 | δ 0.92 (t, 3H)<br>δ 1.41 (h, 2H)<br>δ 2.03 (q, 2H)<br>δ 4.94 (m, 2H)<br>δ 5.80 (m, 1H) |

As shown in the examples and tables, the invention copper compound can be synthesized easily. Examples 1 and 2 are selected examples to explain the invention, and the invention synthesis process is not limited to that described in Examples 1 and 2.

<u>Example 3</u>

The VTMOS solution of (hfac)Cu(VTMOS) and the 1-pentene solution of (hfac)Cu(1-pentene) prepared herein were tested for their thermal stability and copper thin film vapor deposition.

Test 1

Twenty grams of each of the precursor compound solutions prepared at the various ratios in Example 1 were placed in a glass container under a 99.9999% pure-nitrogen stream and the glass container was heated to 80° C. (Hfac)Cu(VTMOS) compound decomposed within 30 minutes when the ligand VTMOS was not added as the solvent. In contrast, the above solutions at 10% weight ratio did not decompose even when heated. This was proof that the thermal stability of the chemical compound had increased.

In another test, a 5 g amount of compound solution was placed in a transparent glass tube and heated to 80° C and evacuated to $10^{-2}$ torr. (Hfac)Cu(VTMOS) without VTMOS as ligand solvent decomposed but the solutions having 10% weight ratio of VTMOS decomposed only slightly while no decomposition was observed in the solutions having above 20% weight ratio. The results are reported in Table 3.

Table 3

| Compound Solution (%) [VTMOS / (hfac)Cu(VTMOS) + VTMOS] x 100 | Thermal Stability - Time | Thermal Stability - Amount of Decomposition |
|---|---|---|
| 0 | Decomposed < 30 minutes | Severe decomposition |
| 2 | Decomposed in about 4 hours | Severe decomposition |
| 10 | Stable > 8 hours | Minute decomposition |
| 20 | Stable > 8 hours | No decomposition |
| 50 | Stable > 8 hours | No decomposition |

On the basis of these results, (hfac)Cu(VTMOS) solution containing 20% VTMOS was tested for copper thin film deposition on a substrate by a chemical vapor deposition process. The substrates used were 2,000 Angstrom thick $SiO_2$ with a vapor deposited 900 Angstrom thick TiN (titanium nitride) layer. The substrate temperature was maintained at 100° to 250° C.

The reactor used had a closed end and an open end which was connected to a vacuum pump ($10^{-2}$ torr). The inside diameter and the length of the reactor were 5 cm and 30 cm, respectively. A 5 mL portion of a precursor solution was placed in a container of similar capacity, and the container was placed in the closed end of the reactor and, in the center of the reactor, several small silicon pieces were placed.

The precursor compositions and substrates were heated by independent heating wires to 80° C and 100° to 250° C, respectively and then, a high purity copper film was deposited while evacuating to $10^{-2}$ torr.

The vapor deposited copper film was subjected to Auger electron spectroscopy ("AES") to determine the impurities in the film, and the surface roughness was determined by a scanning electron microscope ("SEM"). The sheet resistance was measured by a 4-point probe method. The results are summarized in Table 4.

Table 4

| Precursor | Vapor Deposition Conditions | Thin Film |
|---|---|---|
| (hfac)Cu(VTMOS) in 20% VTMOS | Solution Evaporation Temperature: 80° C<br>Substrate Temperature: 100-250° C<br>Reactor Pressure: 1 -10 torr | Resistance: 2.0-2.5 microOhm-cm<br>Impurity: None (by AES)<br>Adhesion Strength: Good<br>Vapor Deposition Rate: 300-2100 Å/min |

Test 2

The (hfac)Cu(1-pentene) solutions in various weight ratios of 1-pentene prepared according to the procedure of Example 2 were used and the thermal stability of each precursor solution was determined by heating the solutions at 35° C according to the procedure of Test 1.

The (hfac)Cu(1-pentene) compound without the addition of 1-pentene was placed in a sealed container under

a nitrogen atmosphere and it decomposed within a few minutes. Also, severe decomposition was observed when placed in a glass tube under vacuum ($10^{-2}$ torr). In contrast, the solutions containing 1-pentene at above 10% had suppressed decomposition for 8 hours in a sealed container, similar to (hfac)Cu(VTMOS) solutions evaluated in Test 1. For all of the solutions containing above 20% solvent, the decomposition of the solutions was not observed in either a sealed container or a glass tube. The results are reported in Table 5.

Table 5

| Compound Solution (%) [1-pentene / (hfac)Cu(1-pentene) + 1-pentene] x 100 | Thermal Stability - Time | Thermal Stability - Amount of Decomposition |
|---|---|---|
| 0 | Decomposed < 30 minutes | Severe decomposition |
| 2 | Decomposed in about 4 hours | Severe decomposition |
| 10 | Stable > 8 hours | Minute decomposition |
| 20 | Stable > 8 hours | No decomposition |
| 50 | Stable > 8 hours | No decomposition |

Based on these results, (hfac)Cu(1-pentene) solution containing 20% 1-pentene was tested for copper thin film deposition by chemical vapor deposition process at 30° C and the vapor deposition conditions and reactor were the same as those used in Test 1, i.e., the silicon substrate temperature was 100° to 250° C. A 5 mL portion of the precursor solution was placed in container of similar capacity, and the container was placed in the reactor and several small silicon pieces were also placed in the reactor.

The vapor deposited copper thin film was subjected to AES, SEM and 4-point probe analysis. These results are listed in Table 6.

Table 6

| Precursor | Vapor Deposition Conditions | Thin Film |
|---|---|---|
| (hfac)Cu(1-pentene) in 20% 1-pentene | Solution Evaporation Temperature: 35° C<br>Substrate Temperature: 100 -200° C<br>Reactor Pressure: 1 - 10 torr | Resistance: 1.8 -2.5 microOhm-cm<br>Impurity: None (by AES)<br>Adhesion Strength: Good<br>Vapor Deposition Rate: 1400 -3500 Å/min<br>Reflectance: Good |

As observed in Tests 1 and 2, the invention compound solutions can be used for copper vapor deposition at a low vapor deposition temperature, 100 to 250° C. In the vapor deposition process using the invention solutions, the solution results in a superior vapor deposition rate on silicon substrates, resistance, impurity contents, adhesion strength, and reflectance compared with known compounds and their solutions. Particularly, in solutions containing above 20% by weight solvent, the thermal stability was outstanding and, thus, the solutions can be processed in a liquid precursor vaporizer, as well as in a direct liquid injector or a liquid delivery system, which is used in the development of reproducible copper thin film vapor deposition processes. These are the advantages of the precursors of the present invention.

**Claims**

**1.** A vapor deposition precursor composition, comprising an organometallic compound of the formula

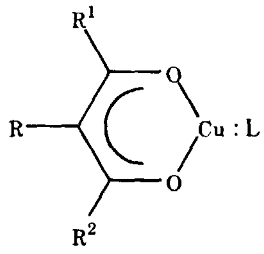

(I)

wherein R is selected from hydrogen, fluorine, perfluoroaryl or alkyl or perfluoroalkyl group of 1 to 4 carbons; $R^1$ and $R^2$ are each independently selected form alkyl or perfluoroalkyl group of 1 to 7 carbons; and L is a Lewis base selected from an organic compound or an organic metal compound capable of providing an unshared pair of electrons to the copper metal center; and a solvent selected from one or more Lewis bases, one or more Lewis acids, or mixtures thereof.

**2.** The composition of claim 1 wherein L is one or more compounds selected from Formulae II to V

$$(R^3)(R^4)C=C(R^5)(R^6 \quad (II)$$

$$R^7C{\equiv}CR^8 \quad (III)$$

$$(R^9)(R^{10})C=CH-(CHR^{11})_n-Si(OR^{12})_3 \quad (IV)$$

$$(R^{10})C{\equiv}C-(CHR^{11})_n-Si(OR^{12})_3 \quad (V)$$

wherein

$R^3$, $R^4$, $R^5$ and $R^6$ are each independently hydrogen, fluorine or alkyl, perfluoroalkyl or alkoxy group of 1 to 6 carbons;
$R^7$ and $R^8$ are each independently hydrogen or alkyl, perfluoroalkyl or alkoxy group of 1 to 6 carbons;
$R^9$, $R^{10}$, $R^{11}$ and $R^{12}$ are each independently hydrogen, fluorine or alkyl, perfluoroalkyl or alkoxy of 1 to 4 carbons; and
n is an integer of 0 to 3.

**3.** The composition of claim 3 wherein L is selected from 1-pentene or vinyltrimethoxysilane.

**4.** The composition of claim 1 wherein the solvent is one or more selected from compounds of Formulae II to VI

$$(R^3)(R^4)C=C(R^5)(R^6) \quad (II)$$

$$R^7C{\equiv}CR^8 \quad (III)$$

$$(R^9)(R^{10})C=CH-(CHR^{11})_n-Si(OR^{12})_3 \quad (IV)$$

$$(R^{10})C{\equiv}C-(CHR^{11})_n-Si(OR^{12})_3 \quad (V)$$

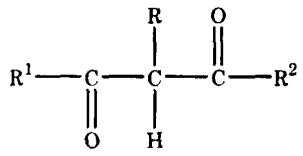

(VI)

wherein

R is selected from hydrogen, fluorine, perfluoroaryl or an alkyl or perfluoroalkyl group of 1 to 4 carbons;
$R^1$ and $R^2$ are independently alkyl or perfluoroalkyl group of 1 to 7 carbons;
$R^3$, $R^4$, $R^5$ and $R^6$ are each independently hydrogen, fluorine or alkyl, perfluoroalkyl or alkoxy group of 1 to 6 carbons;
$R^7$ and $R^8$ are each independently hydrogen or alkyl, perfluoroalkyl or alkoxy group of 1 to 6 carbons;
$R^9$, $R^{10}$, $R^{11}$ and $R^{12}$ are each independently hydrogen, fluorine or alkyl, perfluoroalkyl or alkoxy of 1 to 4 carbons; and
n is an integer of 0 to 3.

**5.** The composition of claim 1 wherein the solvent is a mixture of 1-pentene and 1,1,1,5,5,5-hexafluoro-2,4-pentanedione.

**6.** The composition of claim 5 wherein the amount of 1-pentene is from 20% to 50% by weight of the composition and the amount of 1,1,1,5,5,5-hexafluoro-2,4-pentanedione less than 10% by weight of the composition.

**7.** The composition of claim 1 wherein the solvent is a mixture of vinyltrimethoxysilane and 1,1,1,5,5,5-hexafluoro-2,4-pentanedione.

**8.** The composition of claim 7 wherein the amount of vinyltrimethoxysilane is less than 50% by weight of the composition and the amount of 1,1,1,5,5,5-hexafluoro-2,4-pentanedioneis less than 10% by weight of the composition.

**9.** A process for copper film formation comprising the step of vapor depositing a copper film on a substrate, wherein the source of the copper film is a vapor deposition precursor composition comprising an organometallic compound of the formula

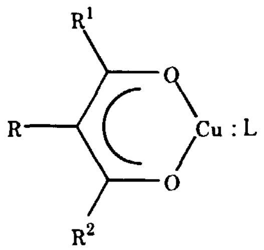

(I)

wherein R is selected from hydrogen, fluorine, perfluoroaryl or alkyl or perfluoroalkyl group of 1 to 4 carbons; $R^1$ and $R^2$ are each independently selected form alkyl or perfluoroalkyl group of 1 to 7 carbons; and L is a Lewis base selected from an organic compound or an organic metal compound capable of providing an unshared pair of electrons to the copper metal center; and a solvent selected from one or more Lewis bases, one or more Lewis acids, or mixtures thereof.

**10.** The process of claim 9 wherein the precursor composition is vaporized by thermal energy, plasma or a bias potential applied to the substrate.